# EUROPÄISCHE PATENTANMELDUNG

(11) **EP 4 415 029 A1**
(43) Veröffentlichungstag der Anmeldung: **14.08.2024**
(21) Anmeldenummer: 23155771.1
(22) Anmeldetag: 09.02.2023
(51) Int. Cl.: H01L 21/48, H01L 23/427, H01L 23/373

(54) **VERFAHREN ZUR HERSTELLUNG EINER KÜHLVORRICHTUNG FÜR EINE HALBLEITERANORDNUNG**

(71) Anmelder: Siemens Aktiengesellschaft, 80333 München (DE)
(72) Erfinder: Schwarz, Florian, 90766 Fürth (DE)
(74) Vertreter: Siemens Patent Attorneys

(57) **Zusammenfassung**

Die Erfindung betrifft ein Verfahren zur Herstellung einer Kühlvorrichtung (2) für eine Halbleiteranordnung (32). Für eine einfache und kostengünstige Herstellung werden folgende Schritte vorgeschlagen: Herstellen (A) eines, insbesondere metallischen, Grundkörpers (4) mit einer ersten Seitenfläche (6) und einer gegenüber der ersten Seitenfläche (6) angeordneten zweiten Seitenfläche (8), wobei durchgängig von der ersten Seitenfläche (6) zur zweiten Seitenfläche (8) verlaufende Kanäle (10) in den Grundkörper (4) eingebracht werden, wobei benachbarte Kanäle (10) jeweils über einen Steg (12) verbunden sind; Einbringen (B) einer Verbindungsnut (16) zwischen benachbarten Kanälen (10) durch teilweises Abtragen des zwischen den benachbarten Kanälen (10) angeordneten Steges (12); hermetisches Verschließen (C) der Kanäle (10) durch stoffschlüssiges Verbinden der Seitenflächen (6, 8) mit jeweils einem Verschlusskörper (20) zur Ausbildung einer geschlossenen Kanalstruktur (18); Befüllen (D) der geschlossenen Kanalstruktur (18) mit einem Wärmetransportfluid (24), sodass sowohl der Grundkörper (4) als auch die Verschlusskörper (20) in unmittelbarem Kontakt mit dem Wärmetransportfluid (24) stehen.

## Beschreibung

Die Erfindung betrifft ein Verfahren zur Herstellung einer Kühlvorrichtung für eine Halbleiteranordnung.

Ferner betrifft die Erfindung eine Kühlvorrichtung für eine Halbleiteranordnung.

Überdies betrifft die Erfindung eine Halbleiteranordnung mit mindestens einer derartigen Kühlvorrichtung.

Darüber hinaus betrifft die Erfindung einen Stromrichter mit mindestens einer derartigen Halbleiteranordnung

Derartige Kühlvorrichtungen kommen in der Regel in einem Stromrichter zum Einsatz. Unter einem Stromrichter ist beispielsweise ein Gleichrichter, ein Wechselrichter, ein Umrichter oder ein Gleichspannungswandler zu verstehen.

Mit der fortschreitenden Miniaturisierung in der Aufbau- und Verbindungstechnik, beispielsweise durch eine planare Aufbau- und Verbindungstechnik, nimmt die Leistungsdichte in Stromrichtern zu. Um Elektronikausfälle durch thermische Überlastungen zu vermeiden, werden daher immer effektivere, aber auch kostengünstigere Konzepte zum Entwärmen von Halbleiterelementen benötigt.

Die Offenlegungsschrift WO 2021/170308 A1 beschreibt ein Verfahren zur Herstellung einer Leistungsmoduleinheit. Um eine Entwärmung der Leistungsmoduleinheit zu verbessern, wird vorgeschlagen, dass Kühlrippen in Aussparungen eines, insbesondere metallischen, Rahmens, positioniert werden, wobei mittels eines thermischen Spritzverfahrens ein erster metallischer Werkstoff auf die Kühlrippen und den Rahmen aufgebracht wird, wobei durch den aufgebrachten ersten metallischen Werkstoff eine stoffschlüssige Verbindung zwischen den Kühlrippen und dem Rahmen hergestellt wird.

Die Offenlegungsschrift EP 4 071 801 A1 beschreibt eine Halbleitermodulanordnung aufweisend einen Kühlkörper und zumindest ein Halbleitermodul, welches auf dem Kühlkörper kontaktiert ist. Um, im Vergleich zum Stand der Technik, eine effektivere Entwärmung und eine kostengünstigere Herstellung zu ermöglichen, wird vorgeschlagen, dass der Kühlkörper einen Kühlkörpergrundkörper und einen Kühlkörperaufsatz umfasst, wobei der Kühlkörperaufsatz auf einer ersten Oberfläche eine Kanalstruktur aufweist, in welcher ein Wärmetransportfluid angeordnet ist, wobei der Kühlkörpergrundkörper eine Kühlkörpergrundkörperoberfläche aufweist, wobei die Kanalstruktur durch eine stoffschlüssige Verbindung mit der Kühlkörpergrundkörperoberfläche des Kühlkörpergrundkörpers hermetisch verschlossen ist, sodass sowohl der Kühlkörperaufsatz als auch der Kühlkörpergrundkörper in unmittelbarem Kontakt mit dem Wärmetransportfluid stehen, wobei durch die hermetisch verschlossene Kanalstruktur und das Wärmetransportfluid eine pulsierende Heatpipe ausgebildet ist, welche mit dem Halbleitermodul (6) in einer thermisch leitfähigen Verbindung steht.

Vor diesem Hintergrund liegt der Erfindung die Aufgabe zugrunde, eine Kühlvorrichtung für eine Halbleiteranordnung anzugeben, welche einfach und kostengünstig zu realisieren ist.

Diese Aufgabe wird erfindungsgemäß durch ein Verfahren zur Herstellung einer Kühlvorrichtung für eine Halbleiteranordnung gelöst, welches folgende Schritte umfasst: Herstellen eines, insbesondere metallischen, Grundkörpers mit einer ersten Seitenfläche und einer gegenüber der ersten Seitenfläche angeordneten zweiten Seitenfläche, wobei durchgängig von der ersten Seitenfläche zur zweiten Seitenfläche verlaufende Kanäle in den Grundkörper eingebracht werden, wobei benachbarte Kanäle jeweils über einen Steg verbunden sind, Einbringen einer Verbindungsnut zwischen benachbarten Kanälen durch teilweises Abtragen des zwischen den benachbarten Kanälen angeordneten Steges, hermetisches Verschließen der Kanäle durch stoffschlüssiges Verbinden der Seitenflächen mit jeweils einem Verschlusskörper zur Ausbildung einer geschlossenen Kanalstruktur, Befüllen der geschlossenen Kanalstruktur mit einem Wärmetransportfluid, sodass sowohl der Grundkörper als auch die Verschlusskörper in unmittelbarem Kontakt mit dem Wärmetransportfluid stehen.

Ferner wird die Aufgabe erfindungsgemäß gelöst durch Kühlvorrichtung für eine Halbleiteranordnung aufweisend einen, insbesondere metallischen, Grundkörper mit einer ersten Seitenfläche und einer gegenüber der ersten Seitenfläche angeordneten zweiten Seitenfläche, wobei der Grundkörper durchgängig von der ersten Seitenfläche zur zweiten Seitenfläche verlaufende Kanäle aufweist, wobei benachbarte Kanäle jeweils über einen Steg verbunden sind, wobei benachbarte Kanäle über eine Verbindungsnut, welche durch teilweises Abtragen des zwischen den benachbarten Kanälen angeordneten Steges eingebracht ist, in einer fluidtechnischen Verbindung stehen, wobei die Kanäle durch stoffschlüssiges Verbinden der Seitenflächen mit jeweils einem Verschlusskörper hermetisch verschlossen sind und eine geschlossene Kanalstruktur ausbilden, wobei die geschlossene Kanalstruktur ein Wärmetransportfluid enthält, wobei sowohl der Grundkörper als auch die Verschlusskörper in unmittelbarem Kontakt mit dem Wärmetransportfluid stehen.

Überdies wird die Aufgabe erfindungsgemäß gelöst durch eine Halbleiteranordnung mit mindestens einer derartigen Kühlvorrichtung.

Darüber hinaus wird die Aufgabe erfindungsgemäß gelöst durch einen Stromrichter mit mindestens einer derartigen Halbleiteranordnung.

Die in Bezug auf das Verfahren nachstehend angeführten Vorteile und bevorzugten Ausgestaltungen lassen sich sinngemäß auf die Kühlvorrichtung, die Halbleiteranordnung und den Stromrichter übertragen.

Der Erfindung liegt die Überlegung zugrunde, die Herstellung einer Kühlvorrichtung mit einer geschlossenen Kanalstruktur, welche beispielsweise als, insbesondere pulsierende, Heatpipe verwendbar ist, dadurch zu vereinfachen, dass ein Grundkörper derart ausgeführt ist, dass dieser einfach und kostengünstig aus Endlosprofilen, z.B. mittels Strangpressen oder Kunststoffextrusion herstellbar ist. Die Kanäle werden durchgängig von einer ersten Seitenfläche zu einer zweiten Seitenfläche, insbesondere vollständig, in den Grundkörper eingebracht, wobei benachbarte Kanäle jeweils über einen Steg verbunden sind. In einem weiteren Schritt wird eine Verbindungsnut zwischen benachbarten Kanälen durch teilweises Abtragen des zwischen den benachbarten Kanälen angeordneten Steges eingebracht, sodass die Kanäle über die Verbindungsnut in einer fluidtechnischen Verbindung stehen. Das Abtragen kann unter anderem mittels eines spanenden Verfahrens, beispielsweise durch einfaches und kostengünstiges Fräsen, erfolgen. In einem weiteren Schritt werden die Kanäle durch stoffschlüssiges Verbinden der Seitenflächen mit jeweils einem Verschlusskörper hermetisch verschlossen, wobei eine geschlossene Kanalstruktur ausgebildet wird. Die stoffschlüssige Verbindung ist beispielsweise durch Schweißen, insbesondere Laserschweißen, Löten oder, insbesondere bei einer Kühlvorrichtung aus Kunststoff, adhäsiv herstellbar. Durch das Einbringen der Verbindungsnut zur Verbindung der Kanäle im Grundkörper kann ein sehr einfacher und kostengünstig herstellbarer Verschlusskörper, welcher insbesondere keine Verbindungskanäle aufweisen muss, verwendet werden. Ein derartiger Verschlusskörper, z.B. ein Metallblech oder Kunststoffplättchen, kann einfach flächig mit der jeweiligen Seitenfläche des Grundkörpers verbunden werden. In einem weiteren Schritt wird die geschlossene Kanalstruktur mit einem Wärmetransportfluid befüllt, sodass sowohl der Grundkörper als auch die Verschlusskörper in unmittelbarem Kontakt mit dem Wärmetransportfluid stehen. Das Wärmetransportfluid kann beispielsweise Wasser, Aceton, Glykol oder Methanol enthalten. Beispielsweise wird die geschlossene Kanalstruktur durch eine fluiddicht verschließbare Öffnung im Grundkörper befüllt. Somit ist durch die geschlossenen Kanalstruktur der Kühlvorrichtung und das Wärmetransportfluid besonders einfach und kostengünstig eine Fluidkühlung, z.B. eine, insbesondere pulsierende, Heatpipe, ausbildbar.

Eine weitere Ausführungsform sieht vor, dass die Verschlusskörper eine zur jeweiligen Seitenfläche des Grundkörpers korrespondierende Kontaktfläche aufweisen und über die Kontaktfläche flächig auf der jeweiligen Seitenfläche anliegend verbunden werden. Weisen sind die Seitenflächen beispielsweise konvex ausgeführt, weist der Verschlusskörper eine dazu korrespondierende konkave Kontaktfläche auf, sodass einfach und kostengünstig eine fluiddichte Verbindung zwischen dem Grundkörper und den Verschlusskörpern herstellbar ist.

Eine weitere Ausführungsform sieht vor, dass durch die geschlossene Kanalstruktur und das Wärmetransportfluid eine pulsierende Heatpipe ausgebildet wird. Eine pulsierende Heatpipe (engl. pulsating heat pipe, PHP), die auch als oszillierende Heatpipe (engl. oscillating heat pipe, OHP) bezeichnet wird, ist eine Vorrichtung zur Wärmeübertragung mit einer geschlossenen Kanalstruktur, in der ein Wärmetransportmedium, insbesondere ein Wärmetransportfluid, angeordnet ist, dass entlang der Kanalstruktur durch die Oberflächenspannung des Wärmetransportmediums abwechselnd Dampfsegmente und Flüssigsegmente bildet. Diese Dampf- und Flüssigsegmente werden durch einen Temperaturgradienten zum Pulsieren beziehungsweise Oszillieren angeregt. An einer Wärmequelle dehnen sich die Dampfsegmente aufgrund der höheren Temperatur aus; zudem siedet flüssiges Wärmetransportmedium dort und nimmt dabei latente Wärme auf. An einer Wärmesenke schrumpfen die Dampfsegmente durch Kondensation gasförmigen Wärmetransportmediums und geben dabei latente Wärme ab. Die lokalen Temperatur- und Druckunterschiede treiben das ständige Pulsieren beziehungsweise Oszillieren der Dampf- und Flüssigsegmente an. Eine derartige pulsierende Heatpipe ist wartungsarm und kostengünstig, insbesondere da im Vergleich zu einer konventionellen Flüssigkeitskühlung, keine Pumpe erforderlich ist.

Eine weitere Ausführungsform sieht vor, dass die Kanäle parallel zueinander und/oder zu einer, insbesondere senkrecht zu den Seitenflächen angeordneten, ebenen Oberfläche des Grundkörpers verlaufend angeordnet werden. Beispielsweise werden Kanäle mit identischem Querschnitt in einer Reihe bzw. Zeile, insbesondere äquidistant zueinander, angeordnet. Eine derartiger Grundkörper ist besonders einfach und kostengünstig als Endlosprofil herstellbar. Ferner wird eine besonders einfache Skalierbarkeit und Weiterverarbeitung ermöglicht.

Eine weitere Ausführungsform sieht vor, dass zumindest zwei Kanäle übereinander senkrecht zu einer ebenen Oberfläche des Grundkörpers verlaufend angeordnet werden. Unter anderem kann der Grundkörper mindestens zwei, insbesondere identische, Kanalreihen umfassen, sodass auf einfache und kostengünstige Weise komplexe dreidimensionale Strukturen realisierbar sind.

Eine weitere Ausführungsform sieht vor, dass der Grundkörper aus einem metallischen Werkstoff mittels Strangpressen hergestellt wird. Insbesondere ist der Grundkörper aus Aluminium oder einer Aluminiumlegierung als Endlosprofil mittels Strangpressen hergestellt. Beispielsweise ist beim Strangpressen eine Aluminiumlegierung mit einem Siliziumanteil von bis 1,0 %, insbesondere bis 0,6 %, verwendbar. Somit ist beim Strangpressen, insbesondere im Vergleich zu einem gegossenen Grundkörper, ein niedriger Siliziumanteil verwendbar, sodass durch das Strangpressen mit einer derartigen Legierung eine verbesserte Wärmeleitfähigkeit erreichbar ist. Ferner ist das Strangpressen von Endlosprofilen kostengünstig und einfach.

Eine weitere Ausführungsform sieht vor, dass der Grundkörper im Wesentlichen ebene Seitenflächen aufweist, wobei die Verschlusskörper als Metallbleche ausgeführt werden. Beispielsweise ist der Grundkörper quaderförmig ausgeführt, sodass sowohl die Herstellung des Grundkörpers als auch die der Metallbleche kostengünstig und einfach ist.

Eine weitere Ausführungsform sieht vor, dass die Verbindungsnuten alternierend im Bereich der Seitenflächen zur Ausbildung einer mäanderartigen Kanalstruktur angeordnet werden. Durch eine derartige mäanderartige Kanalstruktur wird großflächig eine homogene Wärmeabfuhr erreicht.

Eine weitere Ausführungsform sieht vor, dass in den Grundkörper, insbesondere zwischen den Kanälen, Kühlrippen eingefügt werden. Beispielsweise werden die Kühlrippen in Nuten eingefügt, welche ebenfalls kostengünstig und einfach mittels Strangpressen oder Kunststoffextrusion herstellbar sind. Das Fügen der Kühlrippen kann durch eine Pressverbindung und/oder stoffschlüssig, z.B. durch Kleben oder Löten, erfolgen. Durch das Einfügen der Kühlrippen kann beispielsweise auf einen separaten Kühlkörper verzichtet werden, was die Herstellung vereinfacht, und Kosten spart.

Es zeigen:
- FIG 1: eine schematische Darstellung eines Verfahrens zum Herstellen einer Kühlvorrichtung mit einer ersten Ausgestaltung eines Grundkörpers,
- FIG 2: eine schematische dreidimensionale Darstellung einer zweiten Ausgestaltung eines Grundkörpers,
- FIG 3: eine schematische dreidimensionale Darstellung einer dritten Ausgestaltung eines Grundkörpers in einer Vorderansicht,
- FIG 4: eine schematische dreidimensionale Darstellung der dritten Ausgestaltung eines Grundkörpers in einer Rückansicht,
- FIG 5: eine schematische Schnittdarstellung einer Kühlvorrichtung,
- FIG 6: eine schematische Schnittdarstellung einer ersten Ausgestaltung einer Halbleiteranordnung,
- FIG 7: eine schematische Schnittdarstellung einer zweiten Ausgestaltung einer Halbleiteranordnung,
- FIG 8: eine schematische Schnittdarstellung einer dritten Ausgestaltung einer Halbleiteranordnung,
- FIG 9: eine schematische Schnittdarstellung einer vierten Ausgestaltung einer Halbleiteranordnung,
- FIG 10: eine schematische Schnittdarstellung einer fünften Ausgestaltung einer Halbleiteranordnung,
- FIG 11: eine schematische Schnittdarstellung einer Kühlvorrichtung mit L-förmiger Querschnittsfläche,
- FIG 12: eine schematische Schnittdarstellung einer Kühlvorrichtung mit E-förmiger Querschnittsfläche und
- FIG 13: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

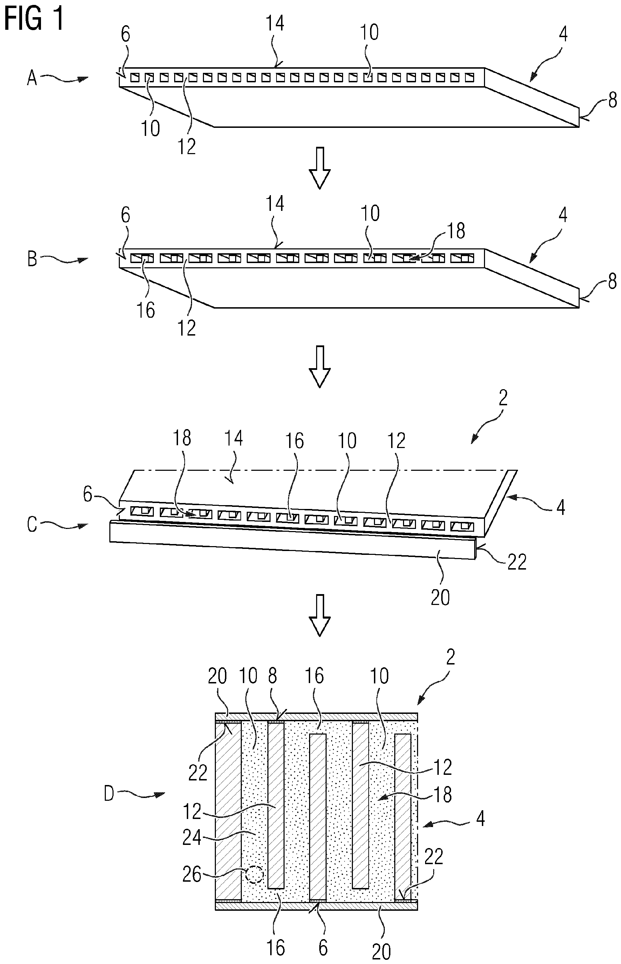

FIG 1 zeigt eine schematische Darstellung eines Verfahrens zum Herstellen einer Kühlvorrichtung 2 mit einer ersten Ausgestaltung eines Grundkörpers 4. Das Verfahren umfasst ein Herstellen A eines metallischen Grundkörpers 4 mit einer ersten Seitenfläche 6 und einer gegenüber der ersten Seitenfläche 6 angeordneten zweiten Seitenfläche 8. Der Grundkörper 4 ist beispielhaft quaderförmig ausgeführt, sodass dieser ebene und parallel zueinander angeordnete Seitenflächen 6, 8 sowie eine senkrecht zu den Seitenflächen 6, 8 angeordnete ebene Oberfläche 14 aufweist. Ferner werden durchgängig von der ersten Seitenfläche 6 zur zweiten Seitenfläche 8 verlaufende Kanäle 10 in den Grundkörper 4 eingebracht, wobei benachbarte Kanäle 10 jeweils über einen Steg 12 verbunden sind. Die parallel zueinander und zur Oberfläche 14 verlaufenden Kanäle 10 weisen in FIG 1 eine im Wesentlichen identische rechteckige, insbesondere quadratische, Querschnittsfläche auf. Beispielsweise beträgt der Kanalquerschnitt
2x2 mm².Zusätzlich sind Kanäle 10 äquidistant zueinander angeordnet. Beispielweise wird der quaderförmige Grundkörper 4 mit den parallel zueinander verlaufenden Kanälen 10 aus Aluminium oder einer Aluminiumlegierung als Endlosprofil mittels Strangpressen hergestellt. Insbesondere wird eine Aluminiumlegierung mit einem Siliziumanteil von bis 1,0 %, insbesondere bis 0,6 %, für das Strangpressen verwendet. Insbesondere im Vergleich zu einem gegossenen Grundkörper, wird durch einen stranggepressten Grundkörper eine verbesserte Wärmeleitfähigkeit erreicht, da beim Strangpressen ein niedriger Siliziumanteil verwendbar ist. Ein stranggepresster Grundkörper aus einer derartigen Aluminiumlegierung ermöglicht eine verbesserte Wärmespreizung. Alternativ kann der Grundkörper 4 mit den parallel zueinander verlaufenden Kanälen 10 aus einem, insbesondere thermisch leitfähigen, Kunststoff als Endlosprofil mittels Kunststoffextrusion hergestellt werden.

In einem weiteren Schritt erfolgt ein Einbringen B einer Verbindungsnut 16 zwischen benachbarten Kanälen 10 durch teilweises Abtragen des zwischen den benachbarten Kanälen 10 angeordneten Steges 12. Das Abtragen kann unter anderem mittels eines spanenden Verfahrens, beispielsweise durch Fräsen, erfolgen. Beim Verfahren in FIG 1 werden die Verbindungsnuten 16 alternierend im Bereich der Seitenflächen 6, 8 zur Ausbildung einer mäanderartigen Kanalstruktur 18 angeordnet.

In einem weiteren Schritt erfolgt ein hermetisches Verschließen C der Kanäle 10 durch stoffschlüssiges Verbinden der Seitenflächen 6, 8 mit jeweils einem Verschlusskörper 20 zur Ausbildung einer geschlossenen Kanalstruktur 18. Die Verschlusskörper 20 weisen eine zur jeweiligen Seitenfläche 6, 8 des Grundkörpers 4 korrespondierende Kontaktfläche 22 auf und werden über die jeweilige Kontaktfläche 22 flächig auf der jeweiligen Seitenfläche 6, 8 anliegend verbunden. Somit stehen benachbarte Kanäle 10 über die jeweilige Verbindungsnut 16 in einer fluidtechnischen Verbindung. Beim Verfahren in FIG 1 sind die Verschlusskörper 20 als Metallbleche mit einer ebenen und glatten Kontaktfläche 22 ausgeführt. Die Metallbleche werden beispielsweise durch Schweißen, insbesondere Laserschweißen, oder Löten mit den Seitenflächen 6, 8 des metallischen Grundkörpers 4 flächig verbunden, sodass die Kanalstruktur 18 hermetisch verschlossen ist.

In einem weiteren Schritt erfolgt ein Befüllen D der geschlossenen Kanalstruktur 18 mit einem Wärmetransportfluid 24, sodass sowohl der Grundkörper 4 als auch die Verschlusskörper 20 in unmittelbarem Kontakt mit dem Wärmetransportfluid 24 stehen. Beispielhaft erfolgt das Befüllen D durch eine fluiddicht verschließbare Öffnung 26. Das Wärmetransportfluid 24 kann beispielsweise Wasser, Aceton, Glykol oder Methanol enthalten. Beispielsweise wird durch die geschlossenen Kanalstruktur 18 und das Wärmetransportfluid 24 eine pulsierende Heatpipe ausgebildet.

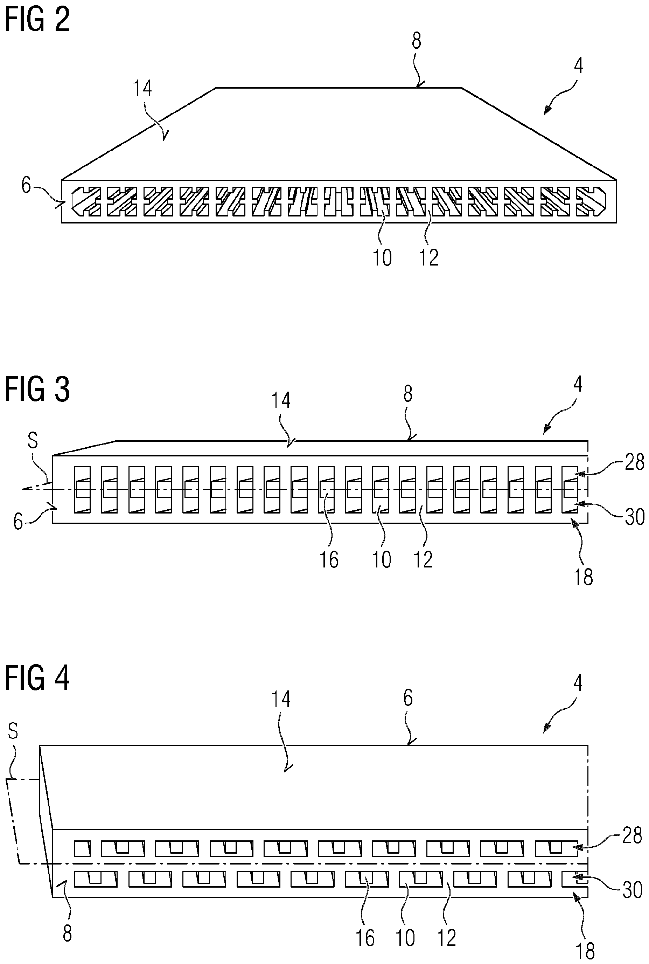

FIG 2 zeigt eine schematische dreidimensionale Darstellung einer zweiten Ausgestaltung eines Grundkörpers 4. Die parallel zueinander und zur Oberfläche 14 verlaufenden Kanäle 10 weisen eine im Wesentlichen identische x-förmige Querschnittsfläche auf, sodass, z.B. im Vergleich zu einer quadratischen Querschnittsfläche, eine größere innere Kontaktfläche der Kanäle 10 zum Wärmetransportfluid 24 erreicht wird. Ein Grundkörper 4 mit Kanälen 10, welche eine x-förmige Querschnittsfläche aufweisen, ist beispielsweise aus Aluminium oder einer Aluminiumlegierung mittels Strangpressen herstellbar. Verbindungsnuten 16 sind in FIG 2 noch nicht eingebracht. Die weitere Ausführung des Grundkörpers 4 in FIG 2 entspricht der in FIG 1.

FIG 3 zeigt eine schematische dreidimensionale Darstellung einer dritten Ausgestaltung eines Grundkörpers 4 in einer Vorderansicht. Der Grundkörper 4 weist beispielhaft zwei übereinander senkrecht zur ebenen Oberfläche 14 des Grundkörpers 4 verlaufend angeordnete Reihen 28, 30 parallel zueinander verlaufender Kanäle 10 auf. Insbesondere sind die im Wesentlichen identisch ausgeführten Kanäle 10 symmetrisch zu einer Symmetrieebene S angeordnet, wobei die Symmetrieebene S parallel zur Oberfläche 14 des Grundkörpers 4 verläuft. Die Verbindungsnuten 16 verlaufen im Bereich der ersten Seitenfläche 6 jeweils zwischen bezüglich der Symmetrieebene S symmetrisch angeordneten benachbarten Kanälen 10. Es wird also eine Kanalverbindung benachbarter Kanälen 10 von der ersten Reihe 28 zur zweiten Reihe 30 hergestellt.

FIG 4 zeigt eine schematische dreidimensionale Darstellung der dritten Ausgestaltung eines Grundkörpers 4 in einer Rückansicht. Im Bereich der zweiten Seitenfläche 8 werden benachbarte Kanäle 10 alternierend innerhalb der jeweiligen Reihe 28, 30 verbunden, wobei die Verbindungsnuten 16 der Reihen 28, 30 um einen Kanal 10 versetzt zueinander angeordnet sind. Nach dem Verschließen der Kanäle 10 wird eine geschlossene dreidimensional-mäanderartige Kanalstruktur 18 ausgebildet. Die weitere Ausführung des Grundkörpers 4 entspricht der in FIG 1.

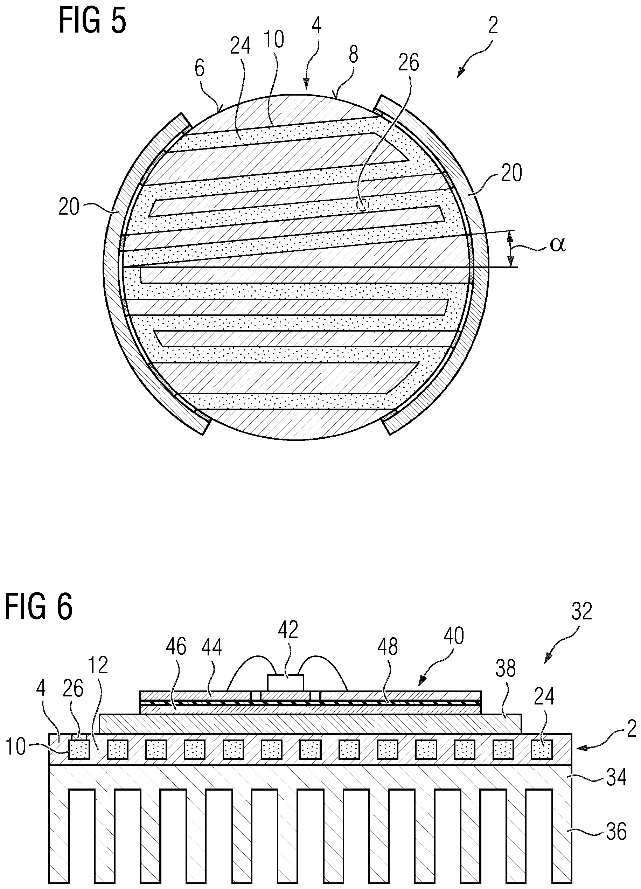

FIG 5 zeigt eine schematische Schnittdarstellung einer Kühlvorrichtung 2, welche einen zylinderförmigen Grundkörper 4 aufweist. Die Kanäle 10 verlaufen teilweise parallel und teilweise in einem spitzen Winkel α zueinander. Die Verbindungsnuten 16 sind alternierend im Bereich der Seitenflächen 6, 8 zur Ausbildung einer mäanderartigen Kanalstruktur 18 angeordnet. Die Verschlusskörper 20 weisen eine zur jeweiligen gewölbten Seitenfläche 6, 8 des Grundkörpers 4 korrespondierende konkave Kontaktfläche 22 auf. Über diese Kontaktfläche 22 werden die Verschlusskörper 20 flächig auf der jeweiligen Seitenfläche 6, 8 anliegend stoffschlüssig verbunden. Die weitere Ausführung des Grundkörpers 4 in FIG 5 entspricht der in FIG 1.

FIG 6 zeigt eine schematische Schnittdarstellung einer ersten Ausgestaltung einer Halbleiteranordnung 32, welche eine Kühlvorrichtung 2 umfasst, die einen quaderförmige Grundkörper 4 aufweist, der aus Aluminium oder einer Aluminiumlegierung mittels Strangpressen hergestellt ist umfasst und als pulsierende Heatpipe ausgebildet ist. Die Kühlvorrichtung 2 ist, insbesondere stoffschlüssig, mit einem metallischen Kühlkörper 34 verbunden, welcher Kühlrippen 36 umfasst. Die stoffschlüssige Verbindung zwischen Kühlvorrichtung 2 und Kühlkörper 34 ist unter anderem durch Löten oder Sintern herstellbar. Auf einer dem Kühlkörper 34 abgewandten Seite der Kühlvorrichtung 2 ist eine Bodenplatte 38 stoffschlüssig, z.B. durch Löten, Kleben oder Sintern, verbunden, auf der ein Substrat 40 mit einem Halbleiterelement 42 angeordnet ist. Zusätzlich oder alternativ kann die Bodenplatte 38 kraftschlüssig, z.B. durch Schrauben oder Bügel, auf die Kühlvorrichtung 2 gepresst sein. Kanäle, durch welche z.B. Schrauben ragen, werden geschlossen. Das Halbleiterelement 42 kann unter anderem als Transistor, insbesondere als Insulated-Gate-Bipolar-Transistor (IGBT), ausgeführt sein. Das Substrat 40 weist eine strukturierte erste Metallisierung 44 auf, auf welcher das Halbleiterelement 42 kontaktiert sind. Die strukturierte erste Metallisierung 44 ist beispielsweise als Kupferkaschierung ausgeführt. Das Halbleiterelement 42 ist stoffschlüssig mit der ersten Metallisierung 44 des Substrats 40 verbunden. Die stoffschlüssige Verbindung wird beispielsweise durch Löten, Kleben oder Sintern hergestellt. Darüber hinaus weist das Substrat 40 eine auf einer dem Halbleiterelement 42 abgewandten Seite eine zweite Metallisierung 46 auf, welche beispielsweise Kupfer enthält und durch eine dielektrische Materiallage 48 von der ersten Metallisierung 8 elektrisch isoliert und thermisch leitfähig verbunden ist. Die dielektrische Materiallage 48 weist beispielsweise eine Stärke von 25 µm bis 400 µm, insbesondere 50 µm bis 300 pm, auf und enthält einen keramischen Werkstoff, beispielsweise Aluminiumnitrid oder Aluminiumoxid, oder einen organischen Werkstoff, beispielsweise einem Polyamid. Insbesondere ist das Substrat 40 als DCB-Substrat ausgeführt. Die zweite Metallisierung 46 des Substrats 40 ist stoffschlüssig, beispielsweise durch Löten, Kleben oder Sintern, mit der Bodenplatte 38 verbunden. Die weitere Ausführung der Kühlvorrichtung 2 in FIG 6 entspricht der in FIG 1.

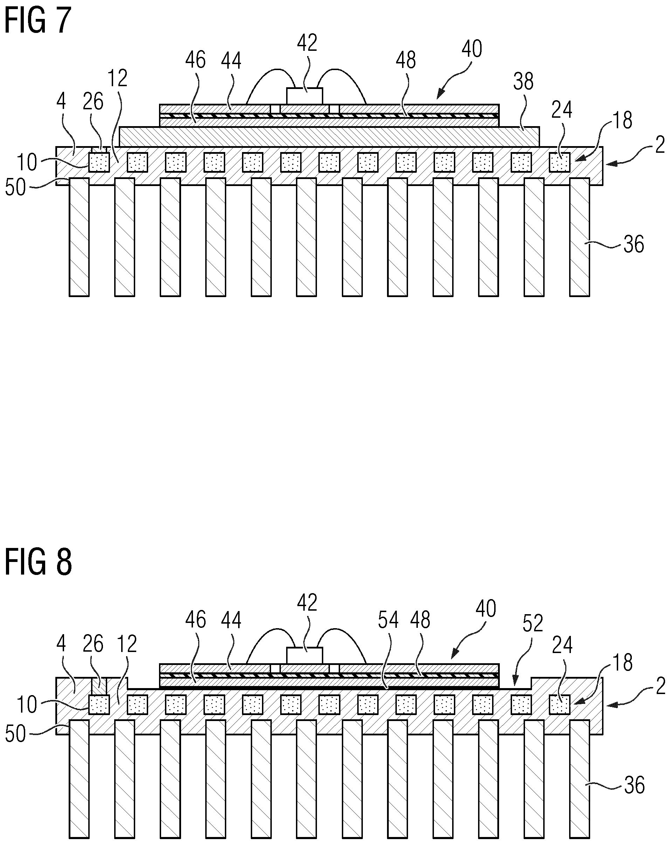

FIG 7 zeigt eine schematische Schnittdarstellung einer zweiten Ausgestaltung einer Halbleiteranordnung 32, wobei in den Grundkörper 4 zwischen den Kanälen 10, Kühlrippen 36 in Nuten 50 eingefügt sind. Die Nuten 50 können beim Strangpressen des Grundkörpers 4 oder nachträglich, z.B. durch Fräsen, eingefügt werden. Die Kühlrippen 36 sind beispielsweise aus Kupfer, Aluminium oder eine deren Legierungen hergestellt. Das Einfügen der Kühlrippen 36 kann durch eine Pressverbindung und/oder stoffschlüssig, z.B. durch Kleben oder Löten, erfolgen. Die weitere Ausführung der Halbleiteranordnung 32 in FIG 7 entspricht der in FIG 6.

FIG 8 zeigt eine schematische Schnittdarstellung einer dritten Ausgestaltung einer Halbleiteranordnung 32, wobei der Grundkörper 4 eine Kavität 52 aufweist, in welcher das Substrat 40 flächig und stoffschlüssig mit dem Grundkörper 4 verbunden ist. Die Kavität 52 kann beim Strangpressen des Grundkörpers 4 oder nachträglich, z.B. durch Fräsen, eingefügt werden. Die stoffschlüssige Verbindung 54 wird beispielsweise durch Löten oder Sintern hergestellt. Durch die unmittelbare Verbindung des Substrats 40 mit dem Grundkörper 4 wird eine verbesserte thermische Anbindung des Halbleiterelements 42 an die Kanalstruktur 18 der Kühlvorrichtung 2 erreicht. Die weitere Ausführung der Halbleiteranordnung 32 in FIG 8 entspricht der in FIG 7.

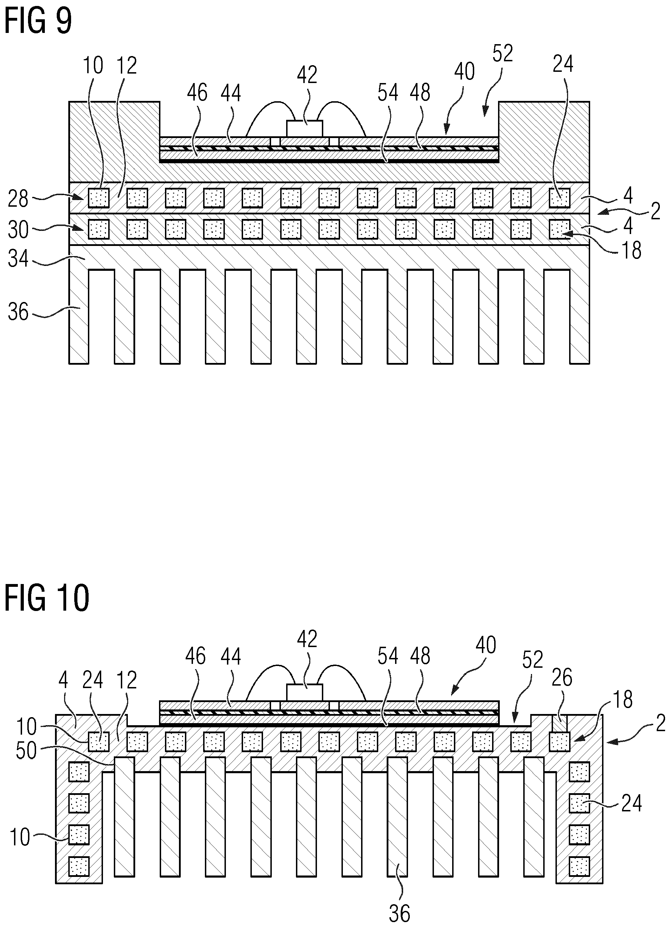

FIG 9 zeigt eine schematische Schnittdarstellung einer vierten Ausgestaltung einer Halbleiteranordnung 32, wobei die Kühlvorrichtung 2 mehrlagig ausgeführt ist. Ein mehrlagiger Aufbau bedeutet, dass exemplarisch zwei im Wesentlichen identisch ausgeführte Strangpressprofile übereinandergestapelt und, beispielsweise stoffschlüssig, miteinander verbunden werden. Es wird, wie in FIG 3 und FIG 4 dargestellt, eine dreidimensional-mäanderartige Kanalstruktur 18 ausgebildet. Die Bodenplatte 38 weist eine Kavität 52 auf, in welcher das Substrat 40 flächig und stoffschlüssig mit dem Grundkörper 4 verbunden ist, sodass eine verbesserte thermische Anbindung des Halbleiterelements 42 an die Kanalstruktur 18 der Kühlvorrichtung 2 erreicht wird. Die weitere Ausführung der Halbleiteranordnung 32 in FIG 9 entspricht der in FIG 6.

FIG 10 zeigt eine schematische Schnittdarstellung einer fünften Ausgestaltung einer Halbleiteranordnung 32, wobei der Grundkörper 4 eine im Wesentlichen U-förmige Querschnittsfläche aufweist. Der Grundkörper 4 ist beispielsweise durch Herstellung eines U-förmigen Strangpressprofils oder durch beidseitiges Falten eines quaderförmigen Strangpressprofils herstellbar. Die weitere Ausführung der Halbleiteranordnung 32 in FIG 10 entspricht der in FIG 8.

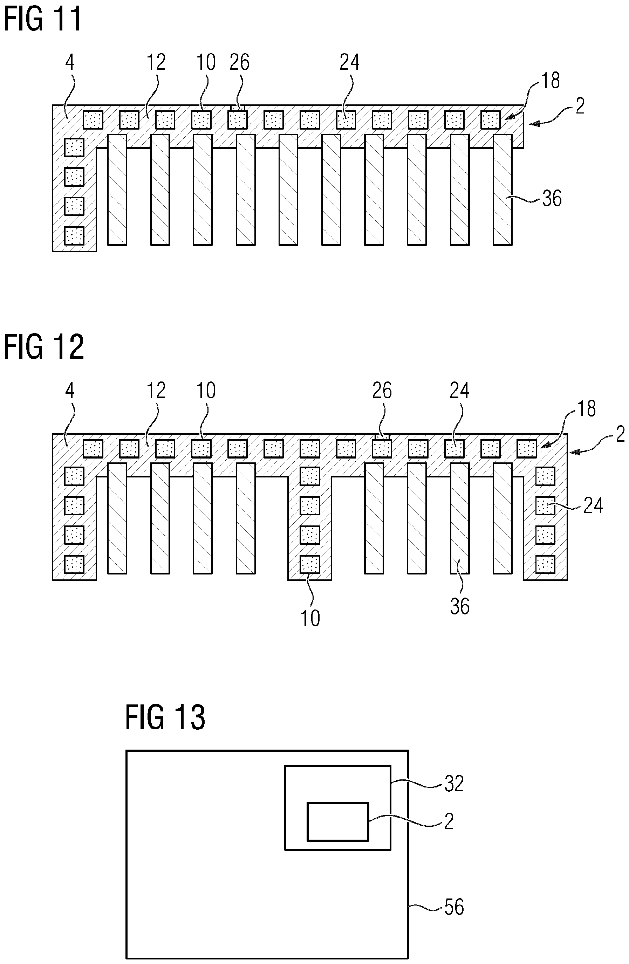

FIG 11 zeigt eine schematische Schnittdarstellung einer Kühlvorrichtung 2 mit L-förmiger Querschnittsfläche. Der Grundkörper 4 ist beispielsweise durch Herstellung eines L-förmigen Strangpressprofils oder durch einseitiges Falten eines quaderförmigen Strangpressprofils herstellbar. Die weitere Ausführung der Kühlvorrichtung 2 in FIG 11 entspricht der in FIG 10.

FIG 12 zeigt eine schematische Schnittdarstellung einer Kühlvorrichtung mit E-förmiger Querschnittsfläche. Der Grundkörper 4 ist beispielsweise durch Herstellung eines E-förmigen Strangpressprofils oder durch zusammenfügen von einem Strangpressprofil mit U-förmigem und einem Strangpressprofil mit L-förmigem Querschnitt herstellbar. Die weitere Ausführung der Kühlvorrichtung 2 in FIG 12 entspricht der in FIG 10.

FIG 13 zeigt eine schematische Darstellung eines Stromrichters 56, welcher beispielhaft eine Halbleiteranordnung 32 aufweist, wobei die Halbleiteranordnung 32 beispielhaft eine Kühlvorrichtung 2 umfasst.

Zusammenfassend betrifft die Erfindung ein Verfahren zur Herstellung einer Kühlvorrichtung 2 für eine Halbleiteranordnung 32. Für eine einfache und kostengünstige Herstellung werden folgende Schritte vorgeschlagen: Herstellen A eines, insbesondere metallischen, Grundkörpers 4 mit einer ersten Seitenfläche 6 und einer gegenüber der ersten Seitenfläche 6 angeordneten zweiten Seitenfläche 8, wobei durchgängig von der ersten Seitenfläche 6 zur zweiten Seitenfläche 8 verlaufende Kanäle 10 in den Grundkörper 4 eingebracht werden, wobei benachbarte Kanäle 10 jeweils über einen Steg 12 verbunden sind; Einbringen B einer Verbindungsnut 16 zwischen benachbarten Kanälen 10 durch teilweises Abtragen des zwischen den benachbarten Kanälen 10 angeordneten Steges 12; hermetisches Verschließen C der Kanäle 10 durch stoffschlüssiges Verbinden der Seitenflächen 6, 8 mit jeweils einem Verschlusskörper 20 zur Ausbildung einer geschlossenen Kanalstruktur 18; Befüllen D der geschlossenen Kanalstruktur 18 mit einem Wärmetransportfluid 24, sodass sowohl der Grundkörper 4 als auch die Verschlusskörper 20 in unmittelbarem Kontakt mit dem Wärmetransportfluid 24 stehen.

## Patentansprüche

1. Verfahren zur Herstellung einer Kühlvorrichtung (2) für eine Halbleiteranordnung (32) umfassend folgende Schritte:
- Herstellen (A) eines, insbesondere metallischen, Grundkörpers (4) mit einer ersten Seitenfläche (6) und einer gegenüber der ersten Seitenfläche (6) angeordneten zweiten Seitenfläche (8),
wobei durchgängig von der ersten Seitenfläche (6) zur zweiten Seitenfläche (8) verlaufende Kanäle (10) in den Grundkörper (4) eingebracht werden,
wobei benachbarte Kanäle (10) jeweils über einen Steg (12) verbunden sind,
- Einbringen (B) einer Verbindungsnut (16) zwischen benachbarten Kanälen (10) durch teilweises Abtragen des zwischen den benachbarten Kanälen (10) angeordneten Steges (12),
- hermetisches Verschließen (C) der Kanäle (10) durch stoffschlüssiges Verbinden der Seitenflächen (6, 8) mit jeweils einem Verschlusskörper (20) zur Ausbildung einer geschlossenen Kanalstruktur (18),
- Befüllen (D) der geschlossenen Kanalstruktur (18) mit einem Wärmetransportfluid (24), sodass sowohl der Grundkörper (4) als auch die Verschlusskörper (20) in unmittelbarem Kontakt mit dem Wärmetransportfluid (24) stehen.

2. Verfahren nach Anspruch 1,
wobei die Verschlusskörper (20) eine zur jeweiligen Seitenfläche (6, 8) des Grundkörpers (4) korrespondierende Kontaktfläche (22) aufweisen und über die Kontaktfläche (22) flächig auf der jeweiligen Seitenfläche (6, 8) anliegend verbunden werden.

3. Verfahren nach einem der Ansprüche 1 oder 2,
wobei durch die geschlossenen Kanalstruktur (18) und das Wärmetransportfluid (24) eine pulsierende Heatpipe ausgebildet wird.

4. Verfahren nach einem der vorherigen Ansprüche,
wobei die Kanäle (10) parallel zueinander und/oder zu einer, insbesondere senkrecht zu den Seitenflächen (6, 8) angeordneten, ebenen Oberfläche (14) des Grundkörpers (4) verlaufend angeordnet werden.

5. Verfahren nach einem der vorherigen Ansprüche,
wobei zumindest zwei Kanäle (10) übereinander senkrecht zu einer ebenen Oberfläche (14) des Grundkörpers (4) verlaufend angeordnet werden.

6. Verfahren nach einem der vorherigen Ansprüche,
wobei der Grundkörpers (4) aus einem metallischen Werkstoff mittels Strangpressen hergestellt wird.

7. Verfahren nach einem der vorherigen Ansprüche,
wobei der Grundkörper (4) im Wesentlichen ebene Seitenflächen (6, 8) aufweist,
wobei die Verschlusskörper (20) als Metallbleche ausgeführt werden.

8. Verfahren nach einem der vorherigen Ansprüche,
wobei die Verbindungsnuten (16) alternierend im Bereich der Seitenflächen (6 ,8) zur Ausbildung einer mäanderartigen Kanalstruktur (18) angeordnet werden.

9. Verfahren nach einem der vorherigen Ansprüche,
wobei in den Grundkörper (4), insbesondere zwischen den Kanälen (10), Kühlrippen (36) eingefügt werden.

10. Kühlvorrichtung (2) für eine Halbleiteranordnung (32) aufweisend einen, insbesondere metallischen, Grundkörper (4) mit einer ersten Seitenfläche (6) und einer gegenüber der ersten Seitenfläche (6) angeordneten zweiten Seitenfläche (8),
wobei der Grundkörper (4) durchgängig von der ersten Seitenfläche (6) zur zweiten Seitenfläche (8) verlaufende Kanäle (10) aufweist,
wobei benachbarte Kanäle (10) jeweils über einen Steg (12) verbunden sind,
wobei benachbarte Kanäle (10) über eine Verbindungsnut (16), welche durch teilweises Abtragen des zwischen den benachbarten Kanälen (10) angeordneten Steges (12) eingebracht ist, in einer fluidtechnischen Verbindung stehen,
wobei die Kanäle (10) durch stoffschlüssiges Verbinden der Seitenflächen (6, 8) mit jeweils einem Verschlusskörper (20) hermetisch verschlossen sind und eine geschlossene Kanalstruktur (18) ausbilden,
wobei die geschlossene Kanalstruktur (18) ein Wärmetransportfluid (24) enthält,
wobei sowohl der Grundkörper (4) als auch die Verschlusskörper (20) in unmittelbarem Kontakt mit dem Wärmetransportfluid stehen.

11. Kühlvorrichtung (2) nach Anspruch 10,
wobei die Verschlusskörper (20) eine zur jeweiligen Seitenfläche (6, 8) des Grundkörpers (4) korrespondierende Kontaktfläche (22) aufweisen und über die Kontaktfläche (22) flächig auf der jeweiligen Seitenfläche (6, 8) anliegend verbunden sind.

12. Kühlvorrichtung (2) nach einem der Ansprüche 10 oder 11,
wobei die Kanäle (10) parallel zueinander und/oder zu einer, insbesondere senkrecht zu den Seitenflächen (6, 8) angeordneten, ebenen Oberfläche (14) des Grundkörpers (4) verlaufend angeordnet sind.

13. Kühlvorrichtung (2) nach einem der Ansprüche 10 bis 12, wobei zumindest zwei Kanäle (10) übereinander senkrecht zu einer ebenen Oberfläche (14) des Grundkörpers (4) verlaufend angeordnet sind.

14. Kühlvorrichtung (2) nach einem der Ansprüche 10 bis 13, wobei der Grundkörper (4) im Wesentlichen ebene Seitenflächen (6, 8) aufweist,
wobei die Verschlusskörper (20) als Metallbleche ausgeführt sind.

15. Kühlvorrichtung (2) nach einem der Ansprüche 10 bis 14,
wobei der Grundkörper (4) eine U-förmige, L-förmige oder E-förmige Querschnittsfläche aufweist.

16. Halbleiteranordnung (32) mit mindestens einer Kühlvorrichtung (2) nach einem der Ansprüche 10 bis 15.

17. Stromrichter (56) mit mindestens einer Halbleiteranordnung (32) nach Anspruch 16.
